# EUROPEAN PATENT APPLICATION

(11) **EP 4 645 381 A1**
(43) Date of publication of application: **05.11.2025**
(21) Application number: 24173349.2
(22) Date of filing: 30.04.2024
(51) Int. Cl.: H01L 23/00

(54) **SEMICONDUCTOR DEVICE WITH CONTROLLED BOND LINE THICKNESS USING SPACERS AND RECESSES**

(71) Applicant: Nexperia B.V., 6534 AB Nijmegen (NL)
(72) Inventor: Yandoc, Ricardo, Manchester, SK7 5BJ (GB); Santican, Haima, Seremban (PH); Dchar, Ilyas, Manchester (GB)
(74) Representative: Pjanovic, Ilija

(57) **Abstract**

A semiconductor device comprising: a die paddle having an upper surface; a solder layer disposed on the upper surface of the die paddle; and a die disposed on the solder layer, such that the solder layer is between the die paddle and the die; wherein the solder layer comprises a plurality of spacers configured to be, during production of the semiconductor device prior to hardening of the solder layer, movable in relation to the die paddle; and wherein the die paddle comprises a plurality of recesses in the upper surface of the die paddle, wherein the plurality of recesses is configured for receiving the plurality of spacers, such that the plurality of spacers is embedded within the plurality of recesses

## Description

### TECHNICAL FIELD

The present disclosure generally relates to semiconductor devices. Particular embodiments relate to a semiconductor device, a method of forming a semiconductor device, and a stencil mask for use in said method.

### BACKGROUND

Soldering dies on die paddles represents an important aspect of semiconductor device manufacturing, playing a role in the assembly and functionality of integrated circuits (ICs) and microelectronic systems. This process usually involves the attachment of semiconductor dies onto die paddles through solder materials, facilitating electrical connections and heat dissipation within the device. The reliable and efficient soldering of dies onto die paddles helps to ensure the performance, reliability, and longevity of semiconductor devices across various applications, including consumer electronics, automotive systems, telecommunications, and industrial equipment.

As the electronics industry moves toward high performance power devices, larger die are increasingly used in a variety of products to achieve superior RDSON performance. To leverage the advantages of larger die, the bond line thickness of solder should be maintained uniformly after reflow process to avoid any degradation of package performances. Nevertheless, achieving a uniform bond line thickness may be quite challenging due to the large soldering area of the die. Optimizing the soldering process becomes increasingly important to meet the demands for reliable and more power-efficient devices.

Semiconductor device manufacturing uses a step called "Die Attach Clip Attach" (DACA). This algorithm is used to regulate and optimize the process of attaching semiconductor dies onto die paddles during assembly, and may involve controlling parameters such as temperature, pressure, and duration of the soldering process to promote precise and reliable attachment while minimizing defects and enhancing device performance and reliability.

Another step in the soldering of electronic components (e.g. the die) onto substrates (e.g. the die paddles) in semiconductor manufacturing is called the "reflow process". This step usually involves heating the solder paste or solder preforms applied to the bonding pads of the components and the corresponding contact areas on the substrate to a temperature where the solder transitions from a solid to a liquid state, typically above its melting point.

During the reflow process, the solder material liquefies, creating a molten state that allows it to flow and form electrical and mechanical connections between some component leads or terminations and corresponding pads or contact areas. This process promotes proper alignment and bonding of the, facilitating the formation of reliable electrical connections for the functioning of the electronic device. In particular, the solder ensures the connection of the die to any substrates, such as the leadframe, in order to form an overall semiconductor package.

Once the solder material is molten and the desired connections are formed, the assembly is cooled, causing the solder to solidify and create permanent, stable connections between the components (e.g. the die) and the substrate (e.g. the die paddle). The reflow process is typically carried out using specialized equipment such as reflow ovens or reflow soldering machines, which control the heating, cooling, and atmosphere conditions to achieve optimal soldering results.

However, it is a known problem that the die can move during the DACA step, as well as during the reflow process.

This may lead to an undesirable effect of non-uniform solder Bond Line Thickness (BLT), wherein the thickness of the solder joint between die and die paddle is not the same (or not at least substantially the same) over the area of the die to be attached.

A reason why this problem may for example occur, is because molten solder may not be strong enough against the weight of a heavy copper clip attached to the die.

Another reason why this problem may for example occur, is that during the reflow process, vaporized solvent in the solder may accidentally move the die.

Another reason why this problem may for example occur, is that pick-up settings may cause die tilt issues (e.g. using an inappropriate collet height, ...).

Each of these reasons, and potentially one or more other reasons as well, may lead to a non-uniform solder BLT, and thus to die tilt.

A non-uniform solder joint and die tilt are likely to create a strain concentration on the thinner side of the solder joint during thermo-mechanical tests. Large die size and thicker dies may worsen the solder reliability, although the problem may also occur for smaller die size and thinner dies.

It has therefore been known to try to control the thickness of the solder joint under the die, at least to a certain level, in order to guarantee a minimum solder BLT.

The benefits of a guaranteed minimum solder BLT may include any one or more of the following:
- It may be applied with different die sizes or a die size range.
- It may help reduce the risk of die crack due to thin BLT at corners of the die.
- It may also help improve reliability performance in thermo-mechanical stress tests due to solder fatigue/degradation, as thin solder BLT may unfortunately contribute to high stress concentration on solder corners, which can result in early solder fatigue failures during Reliability Test Temperature Cycle (TC) and Thermal Fatigue Test (TFAT).

A known approach to attempt to mitigate at least some of the above-described problems, involves the use of nickel or copper support members (in particular spherical spacers), e.g. as disclosed in US 2013/0307130 A1.

### SUMMARY

However, this known approach gives rise to new concerns, because an accumulation or an unequal distribution of support members in one area during the stencil printing process, may still result in die tilting, and may lead to larger solder voids and to support members positioned at one or more corners of the die, which creates a risk of die edge chipping.

In other words, using the known solution of support members may lead to multiple challenges, including any one or more of:
- Solder voids.
- Unequal distribution of solder support members under the die, which may result in severe die tilting.
- Support members located at the edges or corners of the die are likely to lead to die crack, due to thermo-mechanical stress in application.

It is therefore an aim of at least some embodiments according to the present disclosure to address at least some of the above-described shortcomings, namely:
- Avoiding solder voids.
- Avoiding an unequal distribution of solder support members under the die.
- Distributing support members more advantageously instead of at the edges or corners of the die.

Accordingly, there is provided in a first aspect of the present disclosure a semiconductor device comprising:
- a die paddle having an upper surface;
- a solder layer disposed on the upper surface of the die paddle; and
- a die disposed on the solder layer, such that the solder layer is between the die paddle and the die;

wherein the solder layer comprises a plurality of spacers configured to be, during production of the semiconductor device prior to hardening of the solder layer, movable in relation to the die paddle; and
wherein the die paddle comprises a plurality of recesses in the upper surface of the die paddle, wherein the plurality of recesses is configured for receiving the plurality of spacers, such that the plurality of spacers is embedded within the plurality of recesses.

The semiconductor device according to the present disclosure therefore includes a combination of recesses in the die paddle on the one hand, and spacers in the solder layer on the other hand, thus allowing the former to receive and embed the latter.

In this way, the final location of the spacers can be better controlled (by the arrangement of the recesses in the upper surface of the die paddle).

This may help to ensure one or more of the following:
- Solder voids may be avoided, because all or most of the recesses may embed a spacer, such that solder has a chance of reaching all areas under the die.
- The spacers may be more equally distributed under the die.
- The spacers may be more advantageously distributed instead of at the edges or corners of the die.

In other words, the recesses may help to ensure that the spacers are distributed more equally under the die during the reflow process, which may help to avoid die tilting as a result of an (otherwise) unequal distribution of the spacers. This may also help to avoid scattering the spacers to the outside, i.e. at the edges or corners of the die, which scattering might eventually damage the silicon of the die itself, e.g. during thermo-mechanical tests or even in application.

By embedding the spacers in the recesses, and thus distributing the spacers more evenly under the die, before and after the reflow process, it is better possible to maintain a uniform and consistent solder BLT after the reflow process. By maintaining a uniform solder BLT under the die, potential failures missed in reliability tests (such as early solder wearing in actual application) may be better prevented.

The recesses may have a variety of shapes (e.g. indentations, pits, trenches, grooves, canals, ...), as will be further explained below. Likewise, the spacers may have a variety of shapes and may be formed of a variety of materials, as will be further explained below.

In this context, the term 'receiving' may refer to capturing and accommodating.

A "die", or "semiconductor die" usually refers to a chip that can be fabricated on a semiconductor wafer during a manufacturing process. The die may comprise various components, such as transistors, diodes, resistors, and capacitors, and may perform specific functions within the device it is intended for, such as a microprocessor or memory chip.

A "die paddle" usually refers to a flat, typically metallic, area on the surface of a semiconductor die. The die paddle may serve as a heat sink or a connection point for the die within a semiconductor package. Heat generated by the operation of the semiconductor device may be dissipated through the die paddle to prevent overheating, which might affect the device's performance and reliability. Additionally, the die paddle may provide a surface for bonding wires adapted to connect the die to the external leads of the semiconductor package, facilitating electrical connections between the die and the rest of the semiconductor device.

References in the present disclosure to the die paddle may refer to any type of support layer configured for supporting a die. Likewise, references in the present disclosure to the die itself may refer to any type of semiconductor device having a similar form to a die.

It is noted that the spacers are called `movable' in the sense that they may be moved purposefully during the production of the semiconductor device prior to hardening of the solder layer, even if they are securely embedded in the trenches at a later stage of the device's production process, namely after hardening of the solder layer. This can be contrasted with an alternative embodiment, wherein the movable spacers retain, at least to some extent, their potential for motion, within the recesses of the semiconductor device, for example if the spacers are received within the recesses in a loosely-gripping manner allowing some play, for example if the solder layer is not hardened. It is noted that, in this latter, alternative embodiment, the spacers that are, in principle, movable with the recited play, may of course be fixed later on by hardening the solder layer, thus rendering the movable spacers immobile.

In various embodiments, the plurality of recesses is configured for holding the plurality of spacers fixedly.

In this context, the term 'fixedly' may refer to the spacers being attached or placed so as to be immovable, i.e. unable to move or be moved, thus immobile.

In various embodiments, the plurality of recesses is equally distributed over the upper surface of the die paddle.

Preferably, the plurality of recesses may be arranged over the upper surface of the die paddle in a regular pattern, preferably a criss-crossing pattern.

In various further developed embodiments, the plurality of recesses is arranged in the upper surface of the die paddle with a given pitch distance.

In this context, the term 'pitch distance' may refer to the distance between corresponding points on adjacent members of a body of regular form, especially between regularly spaced objects.

In various embodiments, the spacers are configured to be, during production of the semiconductor device prior to hardening of the solder layer, rotatable on the upper surface of the die paddle.

In various embodiments, the spacers comprise granules, preferably spherical particles, most preferably spheres.

In various embodiments, the plurality of spacers comprises at least one spacer formed of copper.

Preferably, the spacers may be made of a metal that has good solderability but does not melt at the solder melting temperature, for example: Cu, Ni, etc. Preferably, all spacers may be formed of copper, Cu.

In various embodiments, the plurality of spacers comprises at least one spacer formed of a compound material, preferably including copper.

In various embodiments, the plurality of spacers comprises at least some spacers formed of a first material and at least some spacers formed of a second material different from the first material.

In other words, some spacers may be formed of one material whereas others may be formed of one or more different materials.

In various embodiments, a thickness of the solder layer, as measured perpendicularly from the plane of the upper surface of the die paddle to the die, is equal to an average height of portions of the spacers of the plurality of spacers, said portions extending (i.e. jutting out) from the plane of the upper surface of the die paddle towards the die.

In various embodiments, a maximum width of the recesses of the plurality of recesses, as measured in the plane of the upper surface of the die paddle, is equal to or greater than the average thickness of the spacers of the plurality of spacers, as measured in the plane of the upper surface of the die paddle.

In various embodiments, a maximum depth of the recesses of the plurality of recesses, as measured perpendicularly from the plane of the upper surface of the die paddle, is at least half of the average thickness of the spacers of the plurality of spacers, as measured perpendicularly from the plane of the upper surface of the die paddle, and is preferably at most 90% of the average thickness of the spacers of the plurality of spacers, as measured perpendicularly from the plane of the upper surface of the die paddle.

In various embodiments, the plurality of recesses comprises a plurality of trenches, preferably a criss-crossing plurality of trenches, more preferably a perpendicularly criss-crossing plurality of trenches.

In various embodiments, at least one, preferably each, recess of the plurality of recesses defines a circular circumference in the plane of the upper surface of the die paddle.

In various embodiments, at least one, preferably each, recess of the plurality of recesses defines a channel extending lengthwise along the upper surface of the die paddle.

In various embodiments, at least one, preferably each, recess of the plurality of recesses defines a plurality of channels extending lengthwise along the upper surface of the die paddle, each channel of said plurality of channels is separated by a channel recess having a circular circumference in the plane of the upper surface of the die paddle, and the channel recess extends deeper into the die paddle than the plurality of channels that the channel recess is separating.

In other words, the channels may comprise longitudinal groove sections separated by capture holes that are deeper than the groove sections.

In various embodiments, each recess of the plurality of recesses defines a rectangular cross-section perpendicular to the plane of the upper surface of the die paddle.

In various embodiments, each recess of the plurality of recesses defines a triangular cross-section perpendicular to the plane of the upper surface of the die paddle, wherein one side of the triangular cross-section lies in the plane of said upper surface.

In various embodiments, each recess of the plurality of recesses defines a circular cross-section perpendicular to the plane of the upper surface of the die paddle, wherein the plane of said upper surface defines a chord of the circular cross-section, preferably the diameter of the circular cross-section.

In various embodiments, the solder layer is contacting the upper surface of the die paddle.

In various embodiments, the die is contacting the solder layer.

Additionally, there is provided in another aspect of the present disclosure a method of forming a semiconductor device; the method comprising:
- providing a die paddle having an upper surface;
- providing a plurality of recesses in the upper surface of the die paddle;
- disposing a mixture on the upper surface of the die paddle, the mixture comprising solder, flux and a plurality of spacers configured to be movable in relation to the die paddle;
- spreading the mixture over the upper surface of the die paddle in order to embed the plurality of spacers in the plurality of recesses, thus forming a solder layer on the die paddle;
- optionally removing excess mixture; and
- disposing a die on the solder layer, such that the die is separated from the die paddle by the plurality of spacers embedded within the plurality of recesses.

In various embodiments, the method may comprise:
- prior to disposing the mixture on the upper surface of the die paddle, disposing a stencil mask on the upper surface of the die paddle, wherein the stencil mask comprises holes arranged in a pattern so as to correspond with the plurality of recesses; and
- after spreading the mixture over the upper surface of the die paddle and prior to disposing the die on the soler layer, removing the stencil mask.

In various embodiments, the method may comprise, after disposing the die on the solder layer, performing one or more post-processing steps including any one or more of the following: curing the solder layer; encapsulating the semiconductor device; and singulating the semiconductor device. Of course, in various further developed embodiments, the method may also comprise specifically any one or more of the following steps:
- disposing another solder layer on the side of the die opposite from the die handle;
- placing a clip on the other solder layer;
- optionally reflowing the solder layers; and
- moulding the semiconductor device.

In various embodiments, the thickness of the stencil mask, as measured perpendicularly from the plane of the upper surface of the die paddle, is at least half the average thickness of the spacers of the plurality of spacers, as measured perpendicularly from the plane of the upper surface of the die paddle.

In various embodiments, the stencil mask comprises at least one tapered slope adapted to facilitate the removal of excess mixture when spreading the mixture.

The skilled person will appreciate that considerations and advantages applicable to embodiments of the semiconductor device may also be applicable to embodiments of the method of forming a semiconductor device, *mutatis mutandis* and *vice versa.*

Additionally, there is provided in another aspect of the present disclosure a stencil mask for use in the method of any one of the above-described embodiments; the stencil mask comprising holes arranged in a pattern so as to correspond with the plurality of recesses in the upper surface of the die paddle.

In various embodiments, the stencil mask comprises at least one tapered slope adapted to facilitate the removal of excess mixture when spreading the mixture.

The skilled person will appreciate that considerations and advantages applicable to embodiments of the semiconductor device may also be applicable to embodiments of the stencil mask, *mutatis mutandis* and *vice versa.*

The embodiments described herein are provided for illustrative purposes and should not be construed as limiting the scope of the invention. It is to be understood that the invention encompasses other embodiments and variations that are within the scope of the appended claims. The invention is not restricted to the specific configurations, arrangements, and features described herein. The invention has wide applicability and should not be limited to the specific examples provided. The embodiments disclosed are merely exemplary, and the skilled person will appreciate that various modifications and alternative designs can be made without departing from the scope of the invention.

### BRIEF DESCRIPTION OF THE DRAWINGS

In the following description, a number of exemplary embodiments will be described in more detail, to help understanding, with reference to the appended drawings, in which:
Figure 1 schematically illustrates a semiconductor device 100 not according to the present disclosure;
Figure 2 schematically illustrates a semiconductor device 200 not according to the present disclosure;
Figure 3A schematically illustrates a first 300A and second 300B semiconductor device not according to the present disclosure, and an exemplary embodiment of a third 300C semiconductor device that is according to the present disclosure;
Figure 3B schematically illustrates an exemplary embodiment of a semiconductor device according to the present disclosure;
Figure 4 schematically illustrates various method steps of an exemplary embodiment of a method according to the present disclosure, in order to produce an exemplary embodiment of a semiconductor device according to the present disclosure, e.g. the device of Figure 3B;
Figure 5 schematically illustrates a specific step of an exemplary embodiment of a method according to the present disclosure; and
Figure 6 schematically illustrates three exemplary embodiments of a semiconductor device according to the present disclosure.

### DETAILED DESCRIPTION

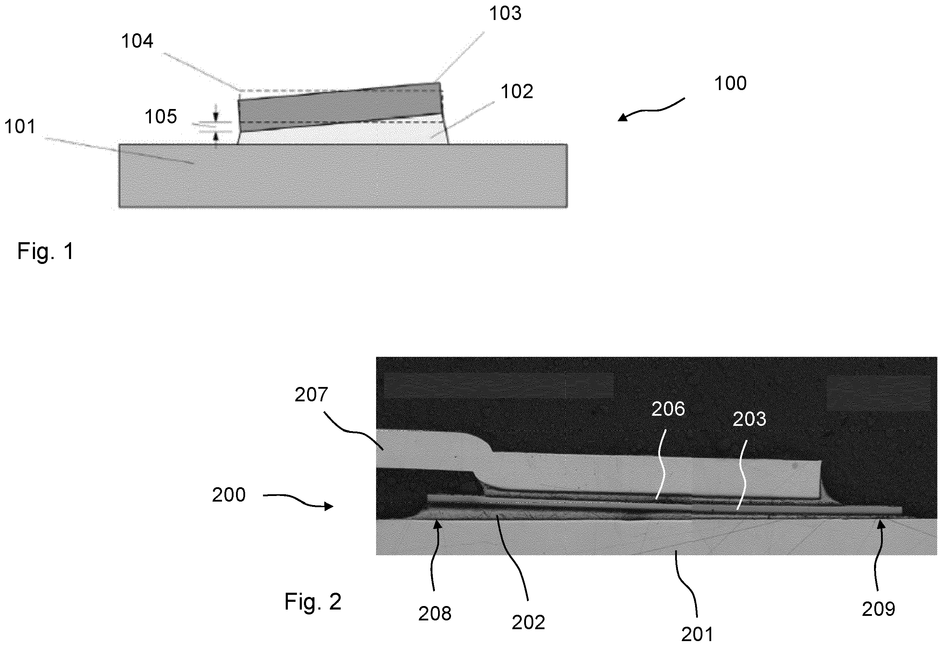

Figure 1 schematically illustrates a semiconductor device 100 not according to the present disclosure.

The device 100 comprises a die paddle 101 (also referred to as a leadframe), a solder layer 102 disposed on the die paddle 101, and a die 103 disposed on the solder layer 102.

The figure shows that, due to various factors, including reflow, as described herein, the solder Bond Line Thickness (BLT) may risk to become non-uniform, due to tilting 105 of the die 103 from its original and intended position 104.

Figure 2 schematically illustrates a semiconductor device 200 not according to the present disclosure.

The figure is a microscopic image showing a die paddle 201, a solder layer 202 disposed on the die paddle 201, and a die 203 disposed on the solder layer 202. Further, a second solder layer 206 is disposed on the die 203, and a clip 207 is disposed on the second solder layer 206.

It can be seen in this real image that, due to tilting of the die 203, e.g. due to reflow, there has appeared a region 208 of the solder layer 206 with 'too much' solder and another region 209 of the solder layer 206 with 'too little' solder.

This is likely to create strain concentration on the thinner side (i.e. region 209) of the solder layer 206, which is undesirable, as has already been explained above.

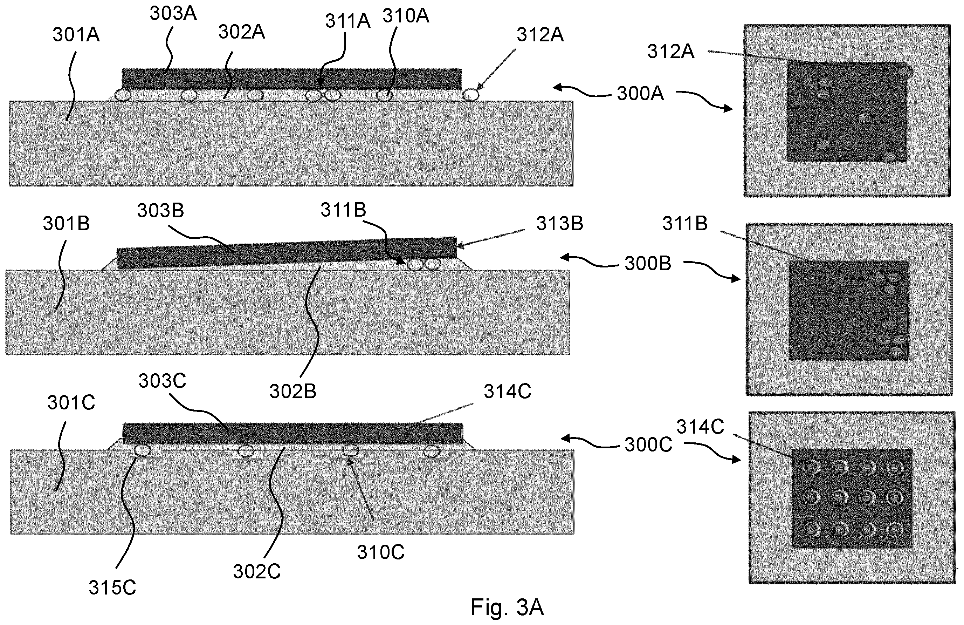

Figure 3A schematically illustrates a first 300A and second 300B semiconductor device not according to the present disclosure, and an exemplary embodiment of a third 300C semiconductor device that is according to the present disclosure.

The first device 300A comprises a die paddle 301A, a solder layer 302A disposed on the die paddle 301A, and a die 303A disposed on the solder layer 302A.

The figure also shows a plurality of spacers 310A, some of which are clustered together 311A, and some of which are positioned 312A perilously at the solder corner, which is undesirable, as has already been explained above, because it may risk the corner of the die 303A to crack.

The figure further shows that the second device 300B has a significant clustering together 311B of spacers 310B at one side of the solder layer 302B, which leads to grave tilting of the die 303B and is therefore undesirable.

The figure also shows a third semiconductor device 300C, which is according to the present disclosure, and which may comprise:
- a die paddle 301C having an upper surface;
- a solder layer 302C disposed on the upper surface of the die paddle 301C; and
- a die 303C disposed on the solder layer 302C, such that the solder layer 302C is between the die paddle 301C and the die 303C.

The solder layer 302C may comprise a plurality of spacers 310C configured to be, during production of the semiconductor device 300C prior to hardening of the solder layer 302C, movable in relation to the die paddle 301C.

The die paddle 301C may comprise a plurality of recesses 315C in the upper surface of the die paddle 301C, wherein the plurality of recesses 315C is configured for receiving the plurality of spacers 310C, such that the plurality of spacers 310C is embedded within the plurality of recesses 315C.

As can be seen, this results in the third semiconductor device 300C to present a well-balanced distribution 314C of spacers, to help produce and maintain a uniform solder BLT.

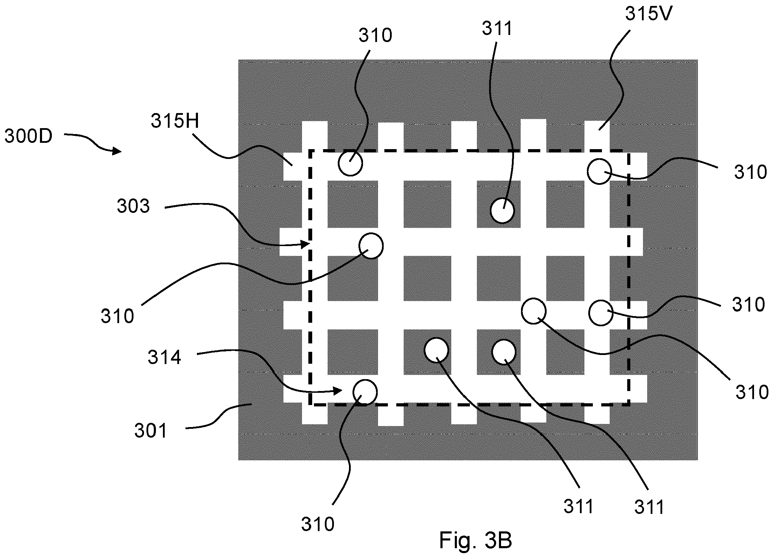

Figure 3B schematically illustrates an exemplary embodiment 300D of a semiconductor device according to the present disclosure, similar to embodiment 300C.

In this exemplary embodiment, the device 300D may comprise a plurality of trenches 315H, 315V. In a particularly preferred implementation, the plurality of trenches 315H, 315V may be arranged in a criss-crossing manner, and more preferably in a perpendicularly criss-crossing manner, i.e. with some trenches 315H aligned along a first axis (in this example figure the horizontal left-to-right axis, but this is of course just an example and is not limiting for realistic implementations) and with other trenches 315V aligned with a second, different axis at a right angle to the first axis (in this example figure the second axis is the vertical top-to-bottom axis, but this is of course just an example and is not limiting for realistic implementations).

The figure shows a plurality of spacers 310, some of which are properly placed 314 but others of which (indicated with reference number 311) are not (yet) properly placed in view of the die intended to be disposed (this die's intended position is indicated with reference number 303). That is, some 311 of the spacers 310 are not yet received and embedded in corresponding recesses 315H, 315V. This may be addressed for example by (further or better) spreading out the solder layer to which the spacers 310 belong across the upper surface of the die paddle 301.

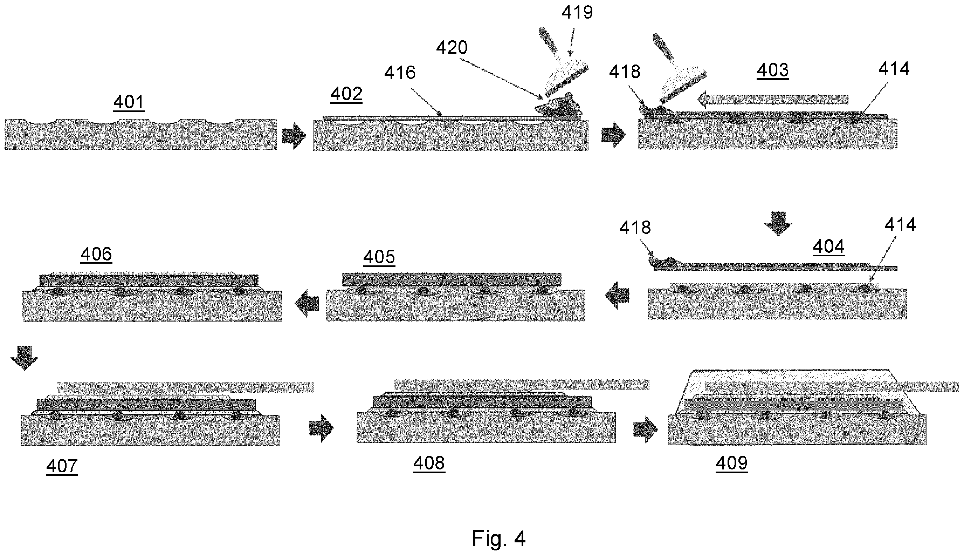

Figure 4 schematically illustrates various method steps of an exemplary embodiment of a method according to the present disclosure, in order to produce an exemplary embodiment of a semiconductor device according to the present disclosure, e.g. the device of Figure 3B.

In step 401, a die paddle is provided with a plurality of recesses in its upper surface.

In step 402, a stencil mask 416 is optionally disposed on the upper surface of the die paddle, and a mixture 420 is disposed, which mixture 420 may contain solder, flux and spacers that can be moved (in particular rolled) in relation to the die paddle. The mixture 420 may be used to form a solder layer.

Also, a squeegee 419 is shown, in order to spread the mixture 420 over the upper surface of the die paddle, in order to embed 414 (shown in step 403) the spacers in the recesses.

Optionally, in step 403, excess mixture 418 may be removed.

In step 404, the optional stencil mask 416 may optionally be removed (handily this may be combined with removing the excess mixture 418), leaving the properly embedded 414 spacers in the recesses.

The above steps leave a solder layer disposed on the die paddle.

In step 405, a die may be disposed on the solder layer.

In step 406, optionally, further solder may be disposed (dispensed or printed) on the die.

In step 407, optionally, a clip may be placed on the further solder.

In step 408, the solder layer(s) may be reflowed.

In step 409, the semiconductor device may be moulded or otherwise packaged.

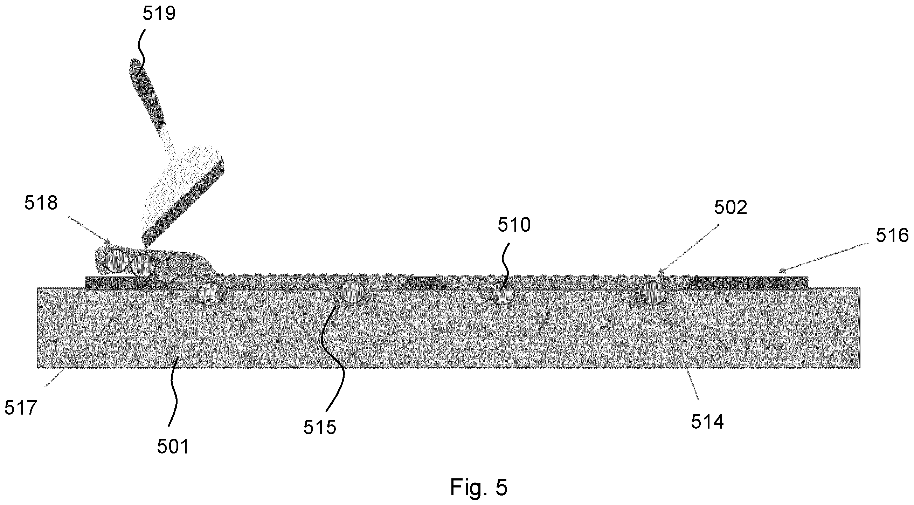

Figure 5 schematically illustrates a specific step of an exemplary embodiment of a method according to the present disclosure.

This figure corresponds to step 403 of Figure 4, except in that the stencil mask 516 comprises at least one tapered slope 517 adapted to facilitate the removal of excess mixture 518 when spreading the mixture. Because the tapered slope 517 nudges any superfluous spacers 510 and/or superfluous solder and/or flux away from the die paddle, this helps to efficiently and effectively produce the solder layer in a clean manner.

Merely as an example implementation choice that is applicable to any of the embodiments according to the present disclosure, the spacers may preferably measure about 70-75 um, the recesses may have a depth of about 45-60 um, and the (optional) stencil mask may have a thickness of about 35 um. These values and especially their relation have been found to be particularly advantageous.

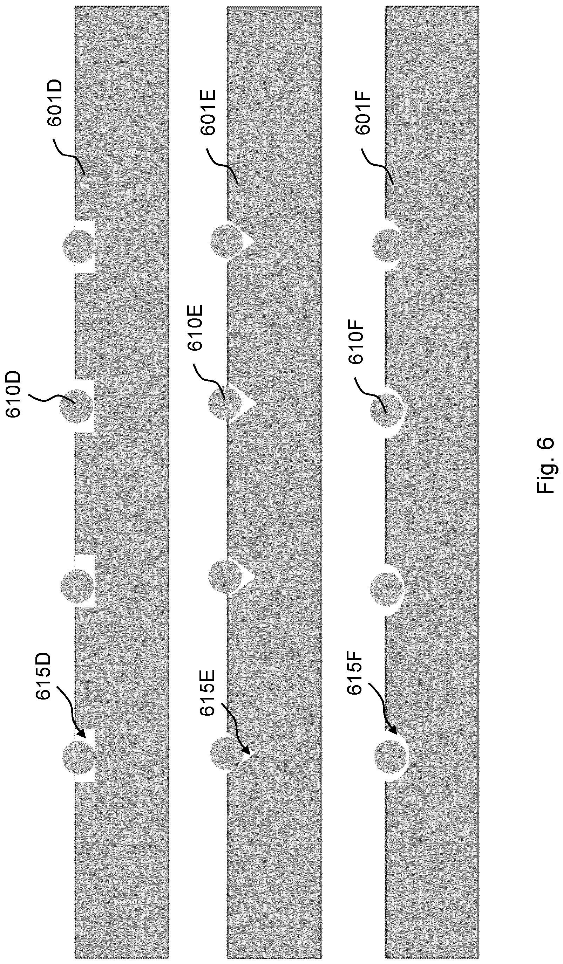

Figure 6 schematically illustrates three exemplary embodiments of a semiconductor device according to the present disclosure.

In a first exemplary embodiment, the recesses 615D define a rectangular cross-section 615D perpendicular to the plane of the upper surface of the die paddle 601D.

In a second exemplary embodiment, the recesses 615E define a triangular cross-section 615E perpendicular to the plane of the upper surface of the die paddle 601E, wherein one side of the triangular cross-section lies in the plane of said upper surface. In other words, one tip of the triangular cross-section is aimed inwards into the die paddle 601E.

In a third exemplary embodiment, the recesses 615F define a circular cross-section 615F perpendicular to the plane of the upper surface of the die paddle 601F, wherein the plane of said upper surface defines a chord of the circular cross-section, preferably the diameter of the circular cross-section. In other words, the round side of the circular cross-section is aimed inwards into the die paddle 601E.

As used in this application and in the claims, the singular forms "a," "an," and "the" include the plural forms unless the context clearly dictates otherwise. The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "obtaining" and "outputting" to describe the disclosed methods. These terms are high-level abstractions of the actual operations that are performed. The actual operations that correspond to these terms will vary depending on the particular implementation and are readily discernible by the skilled person.

It will be appreciated that for simplicity and clarity of illustration, where appropriate, reference numerals may have been repeated among the different figures to indicate corresponding or analogous elements. In addition, numerous specific details are set forth in order to provide a thorough understanding of the examples described herein. However, it will be understood by the skilled person that the examples described herein can be practiced without these specific details. In other instances, methods, procedures and components have not been described in detail so as not to obscure the related relevant feature being described. The drawings are not necessarily to scale and the proportions of certain parts may be exaggerated to better illustrate details and features. The description is not to be considered as limiting the scope of the examples described herein.

Of course, the skilled person will understand that the present invention may be implemented in other ways than those specifically set forth herein without departing from the essential characteristics of the invention. The embodiments described herein are thus to be considered in all respects as illustrative and not restrictive, and all changes within the scope of the appended claims are intended to be embraced therein.

### LIST OF REFERENCE NUMBERS

semiconductor device 100 not according to the present disclosure
die paddle 101
solder layer 102
die 103
tilting 105
original and intended position 104 of die 103
semiconductor device 200 not according to the present disclosure
die paddle 201
solder layer 202
die 203
second solder layer 206
clip 207
region 208 of the solder layer 206 with 'too much' solder
region 209 of the solder layer 206 with 'too little' solder
first 300A semiconductor device not according to the present disclosure
die paddle 301A
solder layer 302A
die 303A
plurality of spacers 310A
spacers clustered together 311A
spacers positioned 312A at the solder corner
second 300B semiconductor device not according to the present disclosure
spacers 310B
clustering together 311B of spacers 310B
solder layer 302B
exemplary embodiment of a third 300C semiconductor device that is according to the
present disclosure
die paddle 301C
solder layer 302C
die 303C
plurality of spacers 310C
plurality of recesses 315C
well-balanced distribution 314C of spacers
exemplary embodiment 300D of a semiconductor device according to the present disclosure
plurality of trenches 315H, 315V
trenches aligned horizontally 315H
trenches aligned vertically 315V
plurality of spacers 310
properly placed spacers 314
improperly placed spacers 311
intended position 303 of die
401-409 steps of method embodiments
stencil mask 416
mixture 420
squeegee 419
spacers embedded 414 in recesses
excess mixture 418
stencil mask 516
tapered slope 517
excess mixture 518
rectangular cross-section 615D
die paddle 601D
triangular cross-section 615E
die paddle 601E
circular cross-section 615F
die paddle 601E

## Claims

1. A semiconductor device comprising:
- a die paddle (301C) having an upper surface;
- a solder layer (302C) disposed on the upper surface of the die paddle; and
- a die (303C) disposed on the solder layer, such that the solder layer is between the die paddle and the die;
wherein the solder layer comprises a plurality of spacers (310C) configured to be, during production of the semiconductor device prior to hardening of the solder layer, movable in relation to the die paddle; and
wherein the die paddle comprises a plurality of recesses (315C) in the upper surface of the die paddle, wherein the plurality of recesses is configured for receiving the plurality of spacers, such that the plurality of spacers is embedded within the plurality of recesses.

2. The semiconductor device of any preceding claim, wherein the plurality of recesses is configured for holding the plurality of spacers fixedly.

3. The semiconductor device of any preceding claim, wherein the plurality of recesses is equally distributed over the upper surface of the die paddle.

4. The semiconductor device of claim 3, wherein the plurality of recesses is arranged in the upper surface of the die paddle with a given pitch distance.

5. The semiconductor device of any preceding claim, wherein the spacers are configured to be, during production of the semiconductor device prior to hardening of the solder layer, rotatable on the upper surface of the die paddle.

6. The semiconductor device of any preceding claim, wherein the spacers comprise granules, preferably spherical particles, most preferably spheres.

7. The semiconductor device of any preceding claim, wherein the plurality of spacers comprises at least one spacer formed of copper.

8. The semiconductor device of any preceding claim, wherein the plurality of spacers comprises at least one spacer formed of a compound material, preferably including copper.

9. The semiconductor device of any preceding claim, wherein the plurality of spacers comprises at least some spacers formed of a first material and at least some spacers formed of a second material different from the first material.

10. The semiconductor device of any preceding claim, wherein a thickness of the solder layer, as measured perpendicularly from the plane of the upper surface of the die paddle to the die, is equal to an average height of portions of the spacers of the plurality of spacers, said portions extending from the plane of the upper surface of the die paddle towards the die.

11. The semiconductor device of any preceding claim, wherein a maximum width of the recesses of the plurality of recesses, as measured in the plane of the upper surface of the die paddle, is equal to or greater than the average thickness of the spacers of the plurality of spacers, as measured in the plane of the upper surface of the die paddle.

12. The semiconductor device of any preceding claim, wherein a maximum depth of the recesses of the plurality of recesses, as measured perpendicularly from the plane of the upper surface of the die paddle, is at least half of the average thickness of the spacers of the plurality of spacers, as measured perpendicularly from the plane of the upper surface of the die paddle, and is preferably at most 90% of the average thickness of the spacers of the plurality of spacers, as measured perpendicularly from the plane of the upper surface of the die paddle.

13. The semiconductor device of any preceding claim, wherein the plurality of recesses comprises a plurality of trenches, preferably a criss-crossing plurality of trenches, more preferably a perpendicularly criss-crossing plurality of trenches.

14. The semiconductor device of any preceding claim, wherein at least one, preferably each, recess of the plurality of recesses defines a circular circumference in the plane of the upper surface of the die paddle.

15. The semiconductor device of any preceding claim, wherein at least one, preferably each, recess of the plurality of recesses defines a channel extending lengthwise along the upper surface of the die paddle.
